# DEMANDE DE BREVET EUROPEEN

(11) **EP 1 182 272 A1**
(43) Date de publication de la demande: **27.02.2002**
(21) Numéro de dépôt: 00202942.9
(22) Date de dépôt: 23.08.2000
(51) Int. Cl.: C23C 14/34, C23C 14/32, H01J 37/34

(54) **Procédé et dispositif permettant le dépôt de couches métalliques en continu par plasma froid**

(71) Demandeur: Cold Plasma Applications C.P.A., 1300 Limal (BE)
(72) Inventeur: VANDEN BRANDE Pierre, 1040 Bruxelles (BE); WEYMEERSCH Alain, 1300 Wavre (BE)
(74) Mandataire: Callewaert, Jean

(57) **Abrégé**

L'invention est relative à un procédé et un dispositif pour le dépôt d'une couche métallique sur un substrat (1) suivant lequel on réalise le dépôt par plasma froid à l'intérieur d'une enceinte de confinement (7) chauffée de manière à éviter la formation d'un dépôt métallique à sa surface, cette enceinte (7) présentant une ouverture d'entrée (21) et une ouverture de sortie (22) par lesquelles le substrat (1) à revêtir entre et sort de celle-ci, une source de vapeur métallique, constituant une électrode, étant prévue dans cette enceinte permettant la formation du plasma (6) dans cette dernière, une contre-électrode étant formée par le substrat (1) ou par un élément conducteur d'électricité séparé. L'invention est caractérisé en ce que l'on introduit le métal, dont il y a lieu de former la couche métallique sur le substrat (1), à l'état liquide dans un bac de rétention (8) communiquant avec l'enceinte de confinement (7) et à ce que l'on maintient le métal liquide dans ce bac (8) à un niveau sensiblement constant durant la formation de cette couche métallique.

## Description

L'invention est relative à un procédé pour le dépôt d'une couche métallique sur un substrat suivant lequel on réalise le dépôt par plasma froid à l'intérieur d'une enceinte de confinement chauffée de manière à éviter la formation d'un dépôt métallique à sa surface, cette enceinte présentant une ouverture d'entrée et une ouverture de sortie par lesquelles le substrat à revêtir entre et sort de celle-ci, une source de vapeur métallique, constituant une électrode, étant prévue dans cette enceinte permettant la formation du plasma dans cette dernière.

Ce procédé permet notamment la métallisation en continu et à haute vitesse de substrats, comme par exemple des bandes, des fils et des poutrelles métalliques (aciers laminés à chaud, aciers laminés à froid, inox, aluminium, cuivre, etc ...), et de substrats non métalliques tels que des feuillards en matériaux polymères ou en papier, ou encore des fibres textiles, des fibres de verres, en particulier des fibres optiques, et des fibres de carbone.

Le document US 3 799 862 et le document EP 0 780 486 A1 décrivent des procédés permettant d'atteindre des vitesses de dépôt très élevées par bombardement de la surface d'un métal fondu ou d'un alliage fondu, contenu dans un creuset, par des ions et des espèces activées générées dans un plasma créé dans une vapeur métallique. Dans ces deux cas, la surface du métal fondu constitue la cathode du système de dépôt. Dans le premier cas l'ionisation de la vapeur métallique est activée par émission thermoïonique d'électrons au moyen d'un filament placé à proximité de la surface du métal. Dans le second cas, un confinement magnétique des électrons à la cathode selon une configuration de type magnétron permet une ionisation importante de la vapeur métallique. Toutefois, rien n'est prévu pour rendre compatible le dispositif de dépôt en continu avec le revêtement de substrats de largeurs variables, ou encore pour pouvoir revêtir des produits longs et étroits, tels que des fils et des fibres, sans pertes importantes de matière.

Une solution a déjà été proposée dans le document WO98/26108 en ce qui concerne l'adaptation pour différentes largeurs de substrats en forme de bande. Cette solution consiste à déplacer la surface de métal, source du plasma, tout en la maintenant relativement proche de la surface des substrats à revêtir pour limiter les pertes latérales, de manière à ce que cette surface de métal recouvre exactement la largeur de la surface à revêtir du substrat. Une telle adaptation de largeur nécessite une régulation précise et compliquée surtout dans le cas où des déplacements latéraux de la surface à revêtir se produisent. Un tel procédé devient, par ailleurs, totalement impropre à la réduction des pertes de matière lors du revêtement de fils et fibres dont les dimensions transverses sont toujours beaucoup plus petites que la plus petite dimension de la surface métallique constituant la source de la vapeur métallique. Cette configuration ne permet d'ailleurs pas d'éviter totalement les pertes latérales qui peuvent devenir critiques lorsque des vitesses de dépôt très élevées sont nécessaires. Tel est le cas du zingage et de l'étamage de tôles d'acier.

Une solution à ce problème consiste à réaliser le dépôt par plasma froid à l'intérieur d'une enceinte de confinement chaude, elle même contenue dans une chambre à vide, tel que décrit dans le document EP 0 908 924 A1. Cependant, la solution décrite dans ce document présente de nombreux inconvénients si elle doit être appliquée au revêtement continu de substrats à des vitesses de dépôt élevées pendant des périodes relativement longues. En effet, l'enceinte de confinement est entièrement polarisée électriquement, positivement ou négativement, pour pouvoir être chauffée soit par bombardement d'ions ou par bombardement d'électrons. Outre les risques de contamination du substrat par érosion des parois de l'enceinte, cette configuration est propice à la formation d'arcs électriques entre l'enceinte de confinement polarisée et la cathode, source de vapeur métallique, et/ou le substrat.

Un des buts essentiels de la présente invention est de fournir des solutions pratiques à ces différents inconvénients et problèmes.

A cet effet, au moins la partie de l'enceinte de confinement voisine à la source de vapeur métallique est maintenue à un potentiel flottant.

Un autre aspect du problème concerne l'alimentation continue en métal liquide du système de dépôt et le contrôle et la régulation de cette alimentation. A très haute vitesse de dépôt, pour des vitesses de lignes élevées, la consommation en métal liquide peut devenir très importante. Afin d'obtenir des conditions de dépôt en régime stationnaire, il est notamment très important de maintenir constante la distance entre le substrat à revêtir et la surface de métal fondu. Il faut donc prévoir une alimentation continue en métal liquide dans le bac afin d'en compenser la consommation. L'alimentation devant être automatique, il faut aussi prévoir un système de contrôle précis de ce niveau non susceptible d'être contaminé par les vapeurs métalliques régnant à l'intérieur de cette enceinte de confinement.

Suivant l'invention, on introduit le métal, dont il y a lieu de former la couche métallique sur le substrat, à l'état liquide dans un bac de rétention communiquant avec l'enceinte de confinement et on maintient le métal liquide dans ce bac à un niveau sensiblement constant durant la formation de cette couche métallique.

Suivant une forme de réalisation particulière de l'invention, l'on chauffe sensiblement uniformément le métal liquide dans le bac de rétention par plasma, en particulier en formant une décharge magnétron à proximité de ce bac, et de préférence au moins partiellement autour de celui-ci. Le métal liquide contenu dans le bac de rétention constitue donc la cathode du dispositif de dépôt, soit d'une manière continue, soit d'une manière discontinue. L'anode peut être le substrat à revêtir et dans ce cas le potentiel de l'anode est le plus souvent celui de la masse de l'installation. L'anode peut aussi être une électrode séparée installée dans l'enceinte de confinement. Dans ce cas elle est chauffée à une température suffisamment élevée pour éviter d'être contaminée par la vapeur métallique et ainsi éviter des courts-circuits. Dans une forme particulièrement intéressante de l'invention, lorsque le dispositif fonctionne en courant alternatif, l'anode peut être réalisée de manière intermittente, à la fréquence de l'alimentation électrique, par un autre bac de rétention alimenté distinctement du premier en métal liquide et placé dans la même enceinte de confinement. Les deux bacs fonctionnent alors successivement en anode et en cathode à la fréquence de l'alimentation électrique. Bien que des fréquences de 1 kHz à 1 MHz soient possibles, les alimentations électriques fonctionnent de manière optimale pour des fréquences comprises entre 10 kHz et 100 kHz.

Suivant une forme de réalisation avantageuse de l'invention, on pèse le bac de rétention afin d'y déterminer le niveau du métal liquide. Le bac est alimenté en métal liquide, en fonction du poids mesuré pour assurer la régulation de ce niveau de métal liquide.

Suivant une forme de réalisation particulièrement avantageuse on alimente le bac de rétention à partir d'un réservoir à métal liquide, dont le niveau de métal liquide est inférieur au niveau de métal liquide dans le bac de rétention, par le réglage du niveau de métal dans le réservoir en fonction du niveau de métal dans le bac de rétention.

L'invention est également relative à un dispositif pour la mise en oeuvre du procédé tel que défini ci-dessus.

Ce dispositif est caractérisé par le fait que des moyens sont sont prévus pour maintenir au moins la partie voisine du bac de rétention à un potentiel flottant et pour isoler électriquement le métal liquide par rapport à l'enceinte.

D'autres détails et particularités de l'invention ressortiront de la description donnée, ci-après, à titre d'exemple non limitatif, de plusieurs formes de réalisation de l'invention avec référence aux dessins annexés.

La figure 1 est une vue schématique en section d'un dispositif suivant une première forme de réalisation de l'invention.

La figure 2 est une vue schématique en section, à plus grande échelle, de l'enceinte de confinement et du bac de rétention de la figure 1.

La figure 3 est une vue schématique en section d'un dispositif suivant une deuxième forme de réalisation de l'invention.

La figure 4 est une vue schématique en section d'un dispositif suivant une troisième forme de réalisation de l'invention.

La figure 5 est une vue schématique en section d'un dispositif suivant une quatrième forme de réalisation de l'invention.

La figure 6 est une vue schématique en section d'un dispositif suivant une cinquième forme de réalisation de l'invention.

La figure 7 est une vue schématique en section d'un dispositif suivant une sixième forme de réalisation de l'invention.

La figure 8 est une vue schématique en section d'un dispositif suivant une septième forme de réalisation de l'invention.

La figure 9 est une section transversale suivant la ligne A-A' de la figure 8.

La figure 10 est une section analogue à celle de la figure 9 pour un dispositif qui est adapté pour le revêtement d'un substrat se présentant sous forme d'un fil.

Dans les différentes figures, les mêmes chiffres de référence se rapportent aux mêmes éléments ou à des éléments analogues.

Le procédé, suivant l'invention, consiste à créer et à confiner dans un espace sensiblement clos maintenu sous vide, traversé d'une manière sensiblement continue par le substrat à revêtir, un plasma froid dans une vapeur métallique générée à partir d'un métal fondu amené en continu de manière régulée dans un bac de rétention. La surface libre du métal liquide contenu dans ce bac est appelé cible. Le plasma est obtenu en polarisant négativement la surface du métal fondu par rapport à une contre-électrode. Ceci peut se faire soit d'une manière continue, la contre-électrode constituant alors une anode, de préférence formée par le substrat à revêtir si ce dernier est suffisamment conducteur, soit d'une manière discontinue en courant alternatif. Dans ce dernier cas, la contre-électrode peut éventuellement être constituée par une autre cible maintenue dans la même enceinte de confinement.

Si le substrat à revêtir est non conducteur d'électricité, la contre-électrode est constituée par un élément conducteur d'électricité séparé.

Il s'agit d'un procédé particulier de dépôt assisté par bombardement d'ions, autrement connu sous la dénomination anglaise "d'ion plating", spécialement conçu pour le revêtement à grande vitesse et en continu de substrats au défilé. Il est bien connu que ce type de technique conduit à la formation de dépôts adhérents et couvrants qui sont plus denses que les films déposés soit par simple évaporation sous vide, soit par pulvérisation cathodique ou "sputtering".

La vapeur métallique précitée et le plasma sont confinés dans une enceinte de confinement constituée d'un matériau à faible coefficient de collage pour la vapeur métallique considérée et suffisamment chaude pour ne pas être contaminée par cette dernière.

Suivant l'invention, au moins la partie de cette enceinte de confinement voisine du bac de rétention du métal liquide est à potentiel flottant pour éviter la formation d'arcs électriques entre cette dernière et le bac de rétention.

L'enceinte de confinement est soit directement, soit indirectement chauffée à un potentiel proche de son potentiel de travail pour éviter la formation d'arcs.

Le chauffage direct a lieu par effet Joule en faisant passer un courant électrique dans les parois de l'enceinte. Le chauffage indirect a lieu par rayonnement au moyen d'une résistance électrique chauffante placée à proximité des parois de l'enceinte de confinement.

Les parois de cette enceinte de confinement sont sensiblement fixes. Il est bien entendu prévu des moyens, comme par exemple des glissières, des fixations centrales ou des pliages, permettant la dilatation des parois tout en assurant le confinement du plasma et de la vapeur métallique lors de leur évolution en température depuis l'arrêt jusqu'en régime de fonctionnement.

Le substrat entre et sort de cette enceinte de confinement fixe par des fentes d'entrée et de sortie ou des trous d'entrée et de sortie de formes adaptées à celles des sections transverses des substrats à revêtir. Ces ouvertures d'entrée et de sortie sont, suivant l'invention, munies de lèvres chaudes destinées à diminuer la conductance au passage du gaz.

L'étanchéité entre le bac de rétention du métal liquide et les parois de l'enceinte de confinement est assurée suivant le même principe.

Des substrats de différents formats, c.à.d. avec des largeurs et des épaisseurs variables, sont revêtus uniformément malgré des déplacements latéraux possibles. La dimension du bac de rétention en métal liquide dans la direction transversale au substrat atteint au moins la valeur de la largeur maximale d'un substrat à traiter, se présentant par exemple sous forme d'une bande.

L'alimentation en métal liquide est assurée en continu à partir d'un four de maintien, extérieur à la chambre à vide, via un tube permettant de reprendre, par la hauteur de la colonne de métal liquide, la différence de pression existant entre le gaz à l'intérieur du four de maintien du métal liquide et l'intérieur de l'enceinte de confinement se trouvant dans la chambre à vide. La particularité de ce système d'alimentation en métal liquide est d'éviter toute liaison mécanique entre le tube et la bac de rétention du métal liquide, de manière à pouvoir contrôler précisément le niveau de ce dernier dans le bac de rétention par sa pesée.

Deux types de moyens peuvent avantageusement être envisagés pour assurer l'indépendance mécanique du tube d'alimentation et du bac de rétention afin de ne pas fausser la mesure du poids de métal liquide contenu dans le bac de rétention.

Une première solution consiste à alimenter le bac par un tube coudé passant au-dessus du rebord du bac et dont l'extrémité plonge dans le métal liquide qui y est contenu sans toucher le bac. Le métal franchit la différence de hauteur entre le rebord du bac et le niveau de métal par effet siphon.

Une seconde solution consiste à faire traverser le fond du bac par le tube d'alimentation tout en maintenant un espace libre entre la surface extérieure du tube et la surface du trou percé dans le fond du bac.

L'étanchéité entre le tube et le bac de rétention, entre lesquels existe donc un jeu, est assurée par la tension superficielle du métal. La hauteur hydrostatique maximale du métal liquide dans le bac de rétention assurant cette étanchéité, mesurée à partir du fond du bac, est par conséquent limitée. Cette hauteur maximale diminue avec l'augmentation du jeu et l'augmentation de la température du métal liquide. Elle est typiquement de quelques centimètres, par exemple dans la cas du zinc et de l'étain, de l'ordre de 3 à 6 cm pour un jeu inférieur à 1 mm.

Ainsi, typiquement, un jeu de l'ordre de 1 mm entre le diamètre extérieur du tube d'alimentation et le diamètre du trou percé dans le fond du bac de rétention, qui permet une hauteur maximale de métal liquide atteignant 4 cm depuis le fond du bac, assure l'étanchéité du dispositif jusqu'à cette hauteur maximale.

L'invention est aussi relative à un procédé et un dispositif particulier permettant de réaliser une décharge magnétron tout autour du bac de rétention de métal liquide traversant l'enceinte de confinement. L'avantage de cette configuration est de permettre un chauffage plus uniforme de la surface du métal et du bac de rétention. Un autre avantage est de permettre la réalisation de sources de métal liquide longues et étroites.

De ce qui précède il résulte que l'invention met en oeuvre plusieurs caractéristiques à l'obtention du but visé, c.a.d. :
1. La présence d'une enceinte de confinement très efficace pour la vapeur métallique et le plasma. Il est préférable d'éviter de contaminer la chambre à vide, et par conséquent les pompes à vide, par un dépôt métallique. Le dépôt métallique doit être réalisé durant un temps très court, qui est généralement moins d'une seconde, sur un substrat défilant en continu et à très grande vitesse dans cette enceinte durant des périodes de production assez longues de, par exemple, sept jours. L'enceinte de confinement est spécialement conçue pour éviter d'être contaminée par le dépôt métallique (matériau constitutif des parois intérieures de l'enceinte à faible coefficient de collage pour la vapeur métallique et possibilité de chauffage des parois), pour réaliser les isolations électriques ne pouvant pas être contaminées par le dépôt, pour permettre l'obtention d'une décharge stable dans la vapeur métallique, c.à.d. sans arcs électriques, mais aussi pour minimiser les pertes en vapeur métallique et les pertes énergétiques du système de dépôt comme cela est expliqué de manière détaillée dans la description des différentes figures et les exemples d'applications pratiques.
2. La présence d'un système d'alimentation en continu du dispositif de dépôt en métal liquide. Ce système est muni d'un dispositif de régulation qui permet de contrôler par pesée, avec une très grande précision, le niveau du métal liquide dans le bac de rétention se trouvant ou affleurant dans l'enceinte de confinement. Ceci est très important, d'une part, pour éviter tout débordement et, d'autre part, pour maintenir le système de dépôt en régime stationnaire de fonctionnement malgré d'inévitables perturbations extérieures, comme par exemple : la consommation de métal par le système de dépôt, les variations de niveau de métal dans le four d'alimentation, la variation de la pression atmosphérique, etc.
3. Une configuration électrique et magnétique particulière permettant un chauffage uniforme de la surface du métal liquide contenu dans le bac de rétention. Cette configuration permet la formation d'une décharge magnétron dans la vapeur métallique tout autour du bac de rétention, ce qui devient indispensable lorsque des produits longs et étroits tels que des fibres doivent être revêtus à très grande vitesse de manière économique. Dans cette configuration, le bac de rétention doit traverser l'enceinte de confinement, être construit dans un matériau conducteur de l'électricité, constituer la cathode du système de dépôt, de manière continue ou discontinue, et se trouver en présence d'un champ d'induction magnétique à l'intérieur de l'enceinte de confinement orienté suivant la direction d'une série de ses génératrices, de manière à ce que ce champ d'induction soit parallèle à sa surface extérieure et l'entoure complètement.

Outre ces trois caractéristiques, plusieurs configurations particulières sont proposées afin de répondre de manière optimale à différentes applications, telles que le revêtement simple face ou double face et l'utilisation de courants alternatifs pour l'obtention de la décharge, par exemple dans un procédé réactif.

Le procédé, suivant l'invention, est de plus naturellement adapté aux variations de formats de bandes en largeur ou en épaisseur, ce qui est indispensable en sidérurgie, mais présente aussi l'avantage d'être insensible aux légers déplacements latéraux du substrat dans l'enceinte de confinement. Il permet la réalisation de dépôts uniformes en épaisseur, à la fois longitudinalement, mais aussi latéralement.

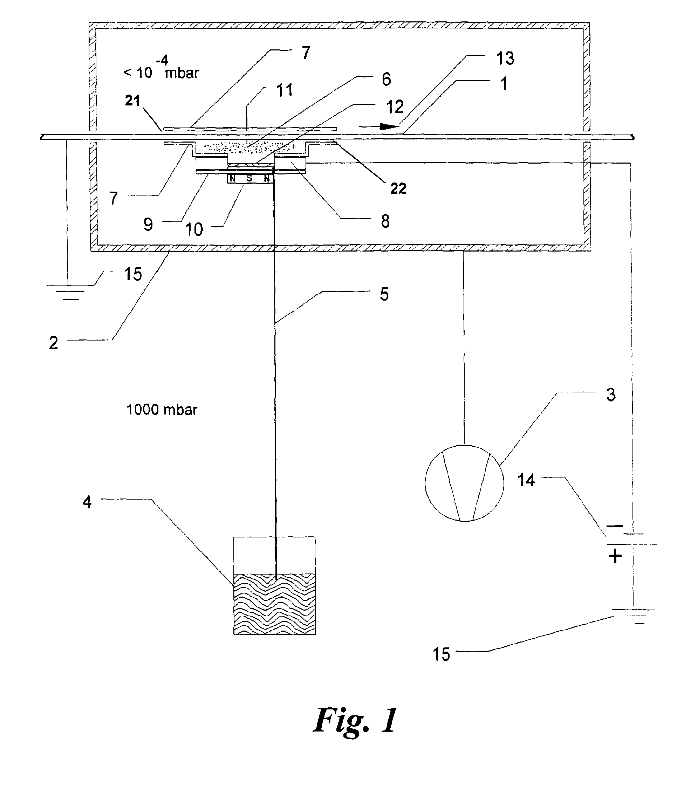

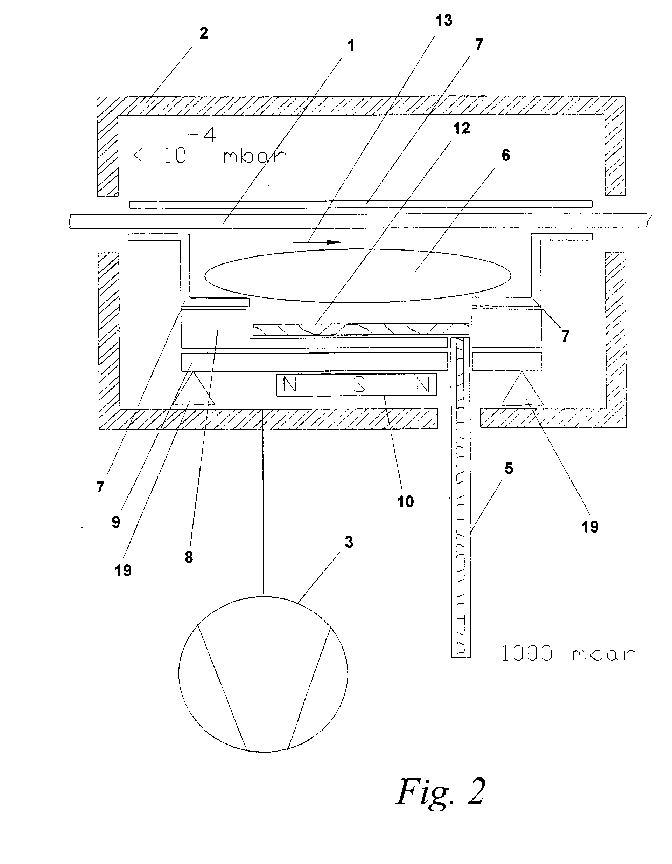

Les figures 1 et 2 représentent un dispositif, suivant l'invention, qui est approprié au revêtement d'une face d'un substrat 1 se présentant sous forme d'une bande qui défile d'une manière sensiblement continue à travers une enceinte de confinement 7 dans le sens indiqué par la flèche 13.

L'enceinte de confinement 7, dans laquelle un plasma 6 et une vapeur métallique sont créés, est à potentiel électrique flottant et est chauffée à une température suffisamment élevée de manière à éviter la formation d'un revêtement métallique sur ses surfaces intérieures.

Le matériau servant à la constitution des surfaces intérieures de l'enceinte 7 est choisi de manière à réduire le coefficient de collage des atomes métalliques en fonction de leur nature. Pour une vapeur métallique qui comprend essentiellement des atomes de zinc, du carbone ou un inox oxydé à chaud est utilisé pour les surfaces intérieures de l'enceinte 7.

Sous cette enceinte de confinement 7 se situe un bac de rétention 8 pour un métal liquide 12. Ce bac de rétention 8, et par conséquent le métal liquide, est isolé électriquement par rapport à la partie inférieure de l'enceinte 7 en maintenant un espace libre entre cette dernière et le bac de rétention 8.

Un tube d'alimentation 5 pour le métal liquide est prévu qui s'étend au travers d'un orifice dans la paroi inférieure du bac de rétention 8. Le tube 5 d'alimentation du métal liquide dans le bac de rétention 8 n'est pas lié à ce dernier. Un jeu relativement important existe, en effet, entre la surface extérieure de ce tube 5 et le contour de l'orifice percé dans le bac 8 pour le passage du tube 5. Le jeu est d'une telle dimension que l'étanchéité entre la surface extérieure du tube 5 et la paroi inférieure du bac 8 est assurée à cause de la tension superficielle du métal liquide, de sorte que le métal ne peut pas s'écouler à travers ce jeu. Ceci permet, d'une part, les dilatations différentielles des matériaux et, d'autre part, le déplacement vertical du tube 5 par rapport au bac de rétention 8.

Afin de déterminer la quantité du métal liquide présent dans le bac de rétention 8 et, par conséquent, de mesurer la consommation de métal liquide par le revêtement du substrat 1, le métal liquide contenu dans le bac de rétention 8 est pesé.

A cet effet, le bac de rétention 8 repose sur des supports 19 qui constituent une balance. Ces supports 19 comprennent, par exemple, un capteur de contrainte piezo-électrique.

L'extrémité du tube d'alimentation 5, opposée à celle qui s'étend à travers le fond du bac de rétention 8, débouche dans un réservoir étanche à métal liquide 4. Le niveau du métal liquide dans ce réservoir 4 est inférieur au niveau de métal liquide dans le bac de rétention 8. Ce réservoir est agencé dans un four électrique, non représenté, qui permet de fondre le métal. La longueur du tube d'alimentation 5 permet de compenser la différence de pression existant entre l'intérieur de la chambre à vide 2 et l'intérieur du réservoir 4 par la hauteur de métal liquide qu'il contient mesurée à partir du niveau de métal dans le réservoir 4.

La puissance électrique du four ne sert qu'à fondre le métal et à le maintenir à l'état liquide dans le réservoir 4, dont l'atmosphère est réductrice ou neutre pour éviter l'oxydation du métal. La pression du gaz présent dans le réservoir 4, au-dessus du métal liquide, est soit égale, soit supérieure à la valeur de la pression atmosphérique extérieure. La régulation de l'alimentation en métal liquide dans le bac de rétention 8 par le tube d'alimentation 5 se fait en modifiant la distance entre le niveau du métal dans le réservoir 4 et le niveau du métal dans le bac de rétention 8, soit en déplaçant verticalement le réservoir, soit en modifiant la valeur de la pression du gaz dans le réservoir 4.

De cette façon, l'alimentation en métal liquide dans le bac de rétention 8 est réglée en fonction du niveau du métal liquide dans ce dernier par variation de la hauteur du niveau du métal liquide contenu dans le réservoir 4. A cet effet, des moyens de réglage sont prévus permettant de déplacer le réservoir 4 dans une direction verticale par rapport au bac de rétention 8 et au tube d'alimentation 5. Un autre moyen consiste à faire varier la hauteur du niveau supérieur de métal liquide contenu dans le réservoir 4, sans modifier la position verticale du réservoir 4, mais en y faisant varier la pression de gaz neutre qui y règne. Par gaz neutre, on comprend un gaz qui ne réagit pas chimiquement avec le métal liquide.

Par ce réglage, il est possible de tenir le niveau du métal liquide dans le bac de rétention 8 sensiblement constant pendant le revêtement d'un ou plusieurs substrats.

Dans la configuration particulière représentée aux figures 1 et 2, une décharge électrique, c.à.d. un plasma, est réalisée dans la vapeur métallique entre la surface du métal liquide 12, constituant une cathode, et le substrat 1, formant une anode, maintenu à la masse 15 au moyen d'un générateur en courant continu 14. Dans cette configuration, la décharge est confinée magnétiquement à proximité de la surface 12 du métal liquide au moyen du circuit magnétique 10 afin d'obtenir une décharge magnétron. Le circuit magnétique 10 est protégé de la chaleur par une isolation thermique 9 refroidie par circulation d'eau.

Les ions et les espèces activées formées dans le plasma et qui bombardent la surface 12 du métal liquide y dissipent suffisamment d'énergie pour permettre son évaporation, de sorte qu' une vapeur métallique est générée. La face inférieure du substrat 1 vient en contact avec la vapeur et le plasma et est ainsi revêtue d'un dépôt métallique, contrairement à sa face supérieure relativement proche de la partie supérieure de l'enceinte de confinement 7. Le substrat 1 est maintenu à une distance de moins de 1 cm de la partie supérieure de l'enceinte 7. Cette proximité limite fortement le passage de la vapeur métallique au-dessus du substrat 1.

On peut montrer que la pression de vapeur métallique varie suivant une loi exponentielle décroissante en fonction du rapport de la distance au bord du produit 1 à la distance séparant le produit de la surface considérée de l'enceinte de confinement 7.

Ce même principe est utilisé dans des fentes d'entrées 21 et de sortie 22 de l'enceinte 7. Les pertes extérieures, c'est-à-dire, dans la chambre à vide 2 entourant l'enceinte de confinement 7, sont extrêmement faibles car la vapeur métallique s'échappant par les fentes 21 et 22 condense principalement sur les surfaces froides du substrat 1, alors que les atomes de la vapeur métallique sont réfléchis par les surfaces chaudes des surfaces intérieures des fentes d'entrée 21 et de sortie 22 de l'enceinte de confinement 7. Pour un rapport de forme de 1 à 10 pour la fente, on peut montrer que la pression partielle en vapeur métallique à la sortie de la fente est 20000 fois plus faible qu'à l'intérieur de l'enceinte de confinement 7. Par un rapport de forme de 1 à 10 est entendu un rapport de 1 à 10 entre la hauteur et la longueur, dans la direction de déplacement du substrat 1, des fentes d'entrée 21 et de sortie 22.

Les pertes en vapeur métallique à travers l'espace libre entre les surfaces chaudes du bac de rétention 8 et celles de l'enceinte de confinement 7 sont elles aussi fortement limitées en réalisant des fentes longues et étroites. Typiquement, on s'arrange pour être en régime d'écoulement moléculaire dans ces fentes. Cette condition est généralement réalisée pour une fente de quelques millimètres de distance entre parois. La distance libre entre l'enceinte 7 et le bac de rétention est donc généralement comprise entre 1 et 5 mm et est de préférence de l'ordre de 2 à 3 mm. Dans ces conditions, pour un rapport entre cette distance et la longueur de la fente de 1 à 33, on peut montrer que la probabilité de transmission d'un atome métallique est de 0,11. Cette probabilité est à multiplier au flux moléculaire pour évaluer l'amplitude de la perte en vapeur métallique.

La chambre à vide 2 est raccordée à un groupe de pompage "haut vide" 3 comprenant généralement des pompes moléculaires, comme par exemple des pompes turbo-moléculaires hybrides, des pompes Root et des pompes primaires.

On cherche habituellement à atteindre une pression de base inférieure à 10⁻² Pa (ou 10⁻⁴ mbar) dans l'enceinte 7, bien que le dispositif de dépôt, suivant l'invention, soit capable de fonctionner en présence d'une pression partielle relativement élevée d'un gaz additionnel à la vapeur métallique, tel que par exemple : Ar, He, N₂, O₂. Dans ce cas, la pression de ce gaz additionnel doit cependant rester inférieure à 1 Pa (ou 10⁻² mbar).

Typiquement, la distance entre la surface du métal liquide 12 et la face à revêtir du substrat 1 doit au moins être de quelques cm, et de préférence au moins 3 cm. Le bac 8 est approvisionné, comme décrit plus haut, au moyen du tube 5 plongeant dans du métal fondu dans un réservoir 4 dont le niveau supérieur du liquide est réglé soit en réglant la pression d'un gaz neutre introduit dans un réservoir 4 étanche soit en montant ou descendant le réservoir 4 par rapport à l'extrémité du tube 5. Le gaz neutre peut comprendre de l'argon, de l'azote et de l'hydrogène, ou un autre gaz neutre.

La mise en route du procédé, suivant l'invention, consiste toujours à injecter un gaz rare tel que de l'argon dans l'enceinte de confinement 7 ou dans la chambre à vide 2 afin de maintenir une pression inférieure à 10 Pa dans l'enceinte 7. Ceci permet de préchauffer le bac de rétention 8 par un plasma produit dans ce gaz rare avant d'introduire le métal liquide dans le bac de rétention 8 via le tube d'alimentation 5. Le gaz rare est injecté au moyen d'un injecteur 11 qui, dans la figure 1, débouche directement dans l'enceinte de confinement 7.

On arrête le procédé en vidant le bac de rétention 8 par le tube d'alimentation 5 et en coupant l'alimentation électrique 14 du dispositif.

Pour atteindre le régime de dépôt, après avoir introduit le métal liquide via le tube 5 dans le bac de rétention 8, l'injection d'argon par exemple est diminuée graduellement de manière à atteindre une pression partielle d'argon inférieure à 1 Pa. Généralement, l'injection d'argon est complètement arrêtée et la pression résiduelle dans la chambre à vide 2 est inférieure à 0,01 Pa (10⁻⁴ mbar) alors que la pression en vapeur métallique dans l'enceinte de confinement 7 dépasse généralement 0,1 Pa (10⁻³ mbar).

En régime de fonctionnement, les densités de puissance moyennes à appliquer à la surface de la cible, c.à.d. à la surface 12 du métal liquide, dépendent bien entendu de la nature du métal, mais restent inférieures à 200 W/cm². En général, la densité de puissance moyenne est comprise entre 5 W/cm² et 100 W/cm² pour des différences de potentiel entre la cathode 12 et l'anode 1 inférieures à 1500 V. Les différences de potentiel entre l'anode et la cathode sont, en général, comprises entre 300 V et 1000 V.

Dans la configuration de la figure 1 et 2, la décharge électrique est préférentiellement réalisée en polarisant négativement la surface 12 de métal liquide en courant continu ou en courant pulsé, par exemple, simplement redressé.

La formation d'un dépôt métallique sur le substrat 1 par condensation simultanée d'atomes évaporés, excités et d'ions métalliques confère au dépôt d'excellentes propriétés physiques telles qu'une très bonne adhérence au substrat 1 et une structure non poreuse à grains fins particulièrement favorable lors des déformations du substrat revêtu en cours d'utilisation. C'est ainsi que ce procédé est particulièrement bien adapté pour le revêtement en continu d'un substrat 1 au défilé par un dépôt de zinc. Cette technique de zingage, tout en permettant de réaliser des dépôts d'excellentes qualités, présente un avantage économique important par rapport aux techniques classiques utilisées actuellement pour le revêtement au défilé d'aciers en forme de fil ou de tôle et au trempé de poutrelles. Ces techniques classiques sont l'électro-zingage et la galvanisation au trempé. Outre une consommation énergétique plus faible à la formation d'un dépôt équivalent, cette nouvelle technique ne nécessite pas la présence d'une usine chimique annexe à la ligne de revêtement pour le traitement des effluents en électrolyse. Elle ne nécessite pas non plus l'investissement lourd dans un four de recuit continu indispensable avant de tremper la tôle dans la cuve de zinc dans une installation de galvanisation au trempé. Le procédé suivant l'invention n'est bien entendu pas limité à ce seul métal, et outre le dépôt de Zn et de ses alliages, il convient au dépôt de tout métal ou alliage métallique pouvant être amené sous forme liquide par le dispositif décrit ci-dessus dans l'enceinte de confinement 7 de la décharge. D'autres métaux qui peuvent être utilisés sont, par exemple l'étain, le magnésium, l'aluminium et leurs alliages. Des adaptations en température et au niveau des matériaux constitutifs de l'enceinte de confinement 7 et du bac de rétention 8 doivent bien entendu être faites pour éviter des problèmes de contamination par la vapeur métallique et de corrosion par le métal liquide en fonction de la nature de ce dernier. Des adaptations doivent aussi être faites quant au choix des matériaux pour le tube 5 et le réservoir 4.

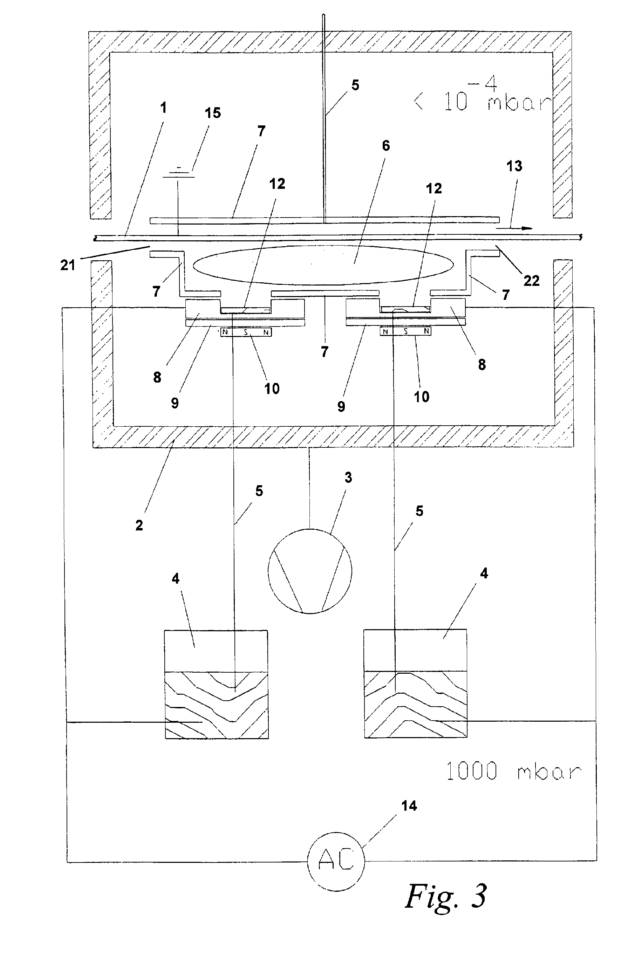

La figure 3 concerne une adaptation jumelle de la configuration précédente représentée aux figures 1 et 2. Cette forme de réalisation permet le revêtement de la face inférieure d'un substrat 1 sous forme de bande défilant dans le sens de la flèche 13. Deux bacs de rétention différents 8 et 8' pour un métal liquide sont prévus en-dessous de l'enceinte de confinement 7. Les deux bacs 8 et 8' peuvent contenir les mêmes métaux ou deux métaux différents. Dans cette configuration, une excitation alternative est utilisée pour polariser négativement, alternativement, les deux surfaces 12 de métal liquide dans les bacs de rétention 8 et 8'. Il est très important que l'alimentation électrique 14 soit totalement isolée électriquement, à la fois des parois de l'enceinte de confinement 7, mais aussi du substrat 1 à revêtir, de manière à former une décharge électrique, c.à.d. un plasma, stable entre les deux bacs de rétention 8 et 8'.

L'alimentation électrique 14 de chaque bac 8 et 8' se fait non seulement au niveau des réservoirs 4 et 4' mais aussi au niveau des bacs 8 et 8' eux-mêmes pour leur préchauffage avant l'introduction du métal liquide via des tubes d'alimentation 5 et 5'. Il est donc évident que dans cette configuration les deux réservoirs 4 et 4' doivent être isolés électriquement par rapport au potentiel du substrat 1, au potentiel des parois de l'enceinte 7, mais aussi l'un par rapport à l'autre.

Le substrat 1 est maintenu à la masse 15. Cette forme de réalisation du dispositif rend possible le revêtement de substrats 1 non conducteurs de l'électricité.

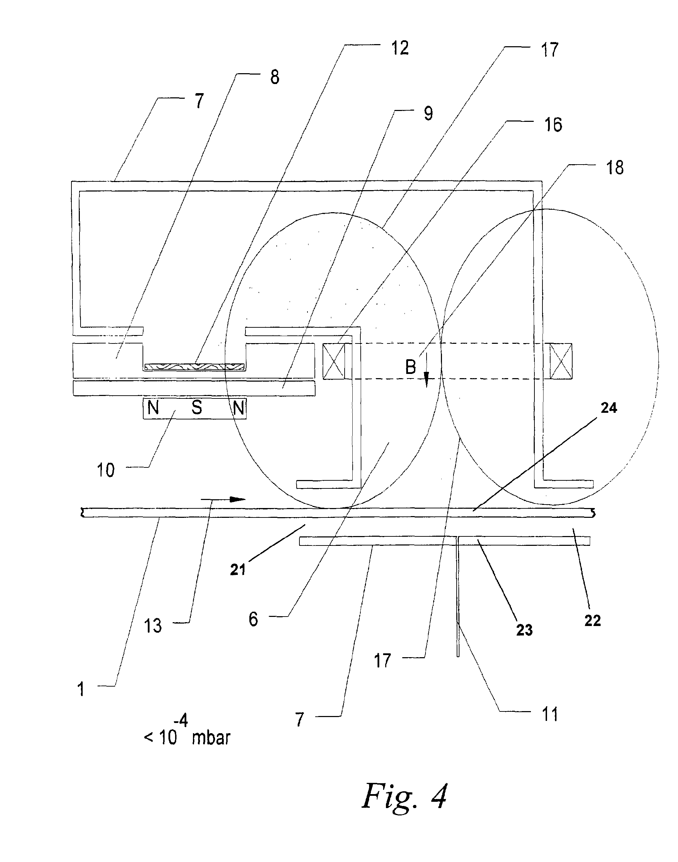

La configuration représentée à la figure 4 est relative au revêtement de la surface supérieure d'un substrat 1 en forme de bande défilant dans une enceinte de confinement 7 présentant une section en forme de L. Bien que non représenté dans la figure, le bac de rétention 8 est alimenté en métal liquide par un tube 5 indépendant mécaniquement du bac 8. Comme dans la forme de réalisation suivant la figure précédente, le bac est connecté à un générateur électrique, non représenté à la figure 4.

Le contrôle du niveau du métal 12 dans le bac de rétention 8 se fait aussi par simple pesée du bac 8. Pour ne pas avoir de dépôt sur la face inférieure du substrat 1, ce dernier est maintenu à proximité de la paroi inférieure 23 de l'enceinte de confinement 7.

L'enceinte de confinement 7 est alimentée en gaz d'argon au démarrage du procédé par un injecteur 11. Pour pouvoir réaliser une décharge électrique dans la vapeur métallique, un champ d'induction magnétique 17 constant est créé au moyen d'un solénoïde 16 afin de permettre aux électrons émis par la surface 12 du métal liquide d'atteindre la surface 24 du substrat 1 à revêtir, ce dernier jouant le rôle d'anode. Le champ d'induction magnétique s'élève typiquement au moins à 0,005 T (ou 50 Gauss), le sens du vecteur 18 du champ d'induction étant indifférent.

Le solénoïde 16 entoure l'enceinte de confinement 7 et est disposé d'une manière telle que le champ magnétique créé est sensiblement transversal à la surface 24 du substrat 1 à revêtir.

L'enceinte de confinement 7 est maintenue à un potentiel flottant, ce qui permet d'éviter la formation d'arcs électriques entre les parois de l'enceinte 7 et le bac de rétention 8 contenant le métal liquide, d'une part, et entre les parois de l'enceinte 7 et le substrat 1 constituant l'anode du dispositif, d'autre part. Un générateur 14, non représenté, polarise négativement le métal liquide 12 par rapport au potentiel électrique du substrat 1 soit en continu, soit de manière alternative, par un courant pulsé. Dans ce dernier cas un courant simplement redressé peut être utilisé.

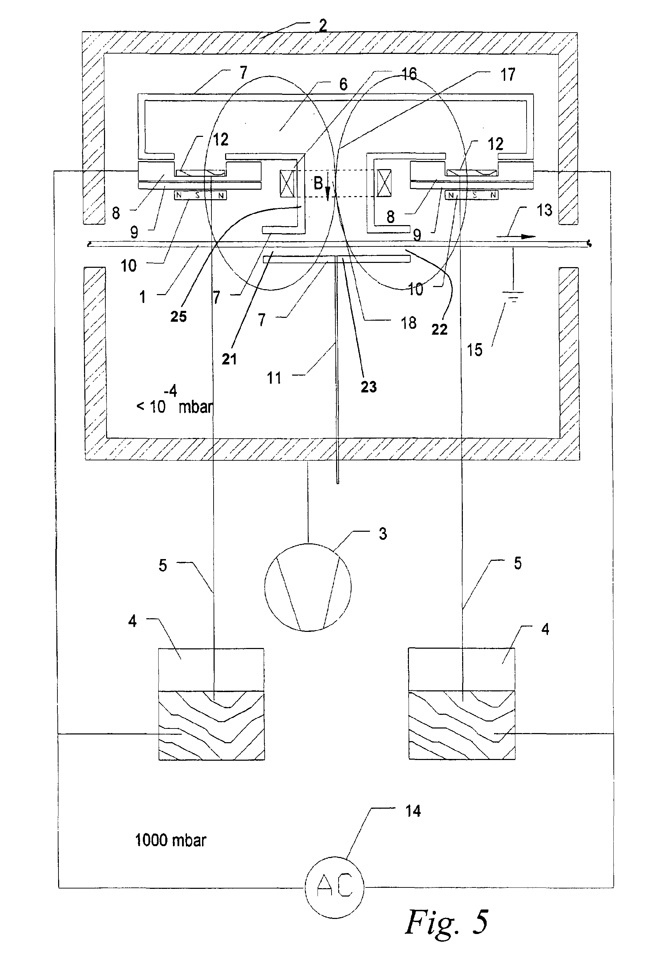

La figure 5 représente une forme de réalisation du dispositif, suivant l'invention, qui comprend deux bacs de rétention 8 et 8' contenant un métal liquide et qui présente une enceinte de confinement 7 en forme de T. L'enceinte 7 montre ainsi, entre les deux bacs de rétention 8 et 8', une partie verticale tubulaire 25 entourée d'un solénoïde 16. Une ouverture d'entrée 21 et de sortie 22 pour un substrat 1 sont prévues dans la partie inférieure de cette partie tubulaire 25 de l'enceinte de confinement 7.

Dans cette configuration, une excitation alternative est utilisée pour polariser négativement, alternativement, les deux surfaces 12 de métal liquide dans les bacs de rétention 8 et 8'. Il est très important de prévoir une alimentation électrique 14 qui soit totalement isolée des parois de l'enceinte de confinement 7, mais aussi du substrat 1 à revêtir, de manière à former une décharge électrique, c.à.d. un plasma, stable entre les deux bacs de rétention 8 et 8'. L'alimentation électrique de chaque bac de rétention se fait non seulement au niveau des réservoirs 4 et 4', mais aussi au niveau des bacs 8 et 8' eux-mêmes pour leur préchauffage avant introduction du métal liquide via des tubes 5 et 5'. Il est donc évident que dans cette configuration les deux réservoirs 4 et 4' doivent être isolés électriquement par rapport au potentiel du substrat, au potentiel des parois de l'enceinte de confinement 7, mais aussi l'un par rapport à l'autre.

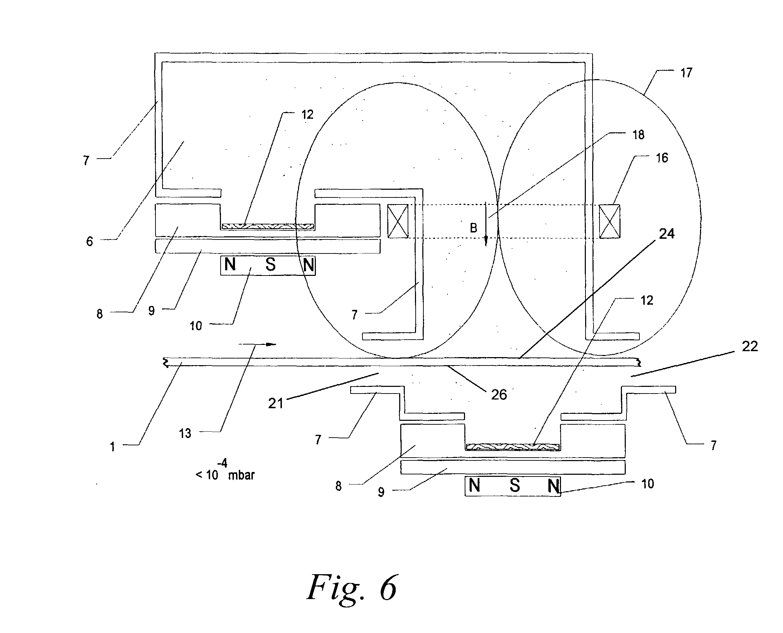

Le dispositif représenté à la figure 6 permet le revêtement simultané des deux faces d'un substrat 1 en forme de bande, ou d'une série de fils, ou encore de poutrelles traversant l'enceinte de confinement 7. Ce dispositif est analogue à celui de la figure 4 à part le fait qu'un deuxième bac de rétention 8' est prévu en-dessous du substrat 1, comme dans la figure 1. Le revêtement de la face supérieure 24 du substrat 1 nécessite la présence d'un champ d'induction 17 produit par un solénoïde 16. La face inférieure 26 du substrat 1 est revêtue à partir du métal liquide contenu dans le bac de rétention 8' inférieur. Le substrat qui défile dans l'enceinte de confinement 7 à travers une ouverture d'entrée 21 et de sortie 22 joue le rôle d'anode. Les parois de l'enceinte de confinement 7 sont maintenues à potentiel flottant, notamment de manière à permettre d'éviter la formation d'arcs électriques, comme déjà mentionné ci-dessus.

Les deux bacs de rétention 8 et 8' sont alimentés en continu en métal liquide au moyen de tubes 5 et 5', non représentés à la figure, mécaniquement indépendants des bacs de rétention 8 et 8', de sorte que la régulation de niveau par pesée des bacs de rétention 8 et 8' soit possible. Les parois de l'enceinte de confinement 7 aussi bien que les bacs 8 et 8' sont à température suffisamment élevée pour éviter d'être contaminés par la vapeur métallique formée dans l'enceinte 7. Les pertes en vapeur métallique sont limitées par l'utilisation de joints en formes de fentes à la fois au niveau des ouvertures d'entrée et de sortie du ou des substrats, mais aussi dans les espaces libres situés entre les surfaces supérieures des bacs de rétention 8 e 8' et les parois de l'enceinte de confinement 7 qui leur sont adjacentes.

Dans une autre configuration, il est possible de connecter les deux bacs de rétention 8 et 8' à un générateur en courant alternatif afin de diminuer la probabilité d'apparition d'arcs. Cependant, dans ce cas il faut que ce générateur soit électriquement isolé à la fois de l'enceinte de confinement 7 et du substrat 1.

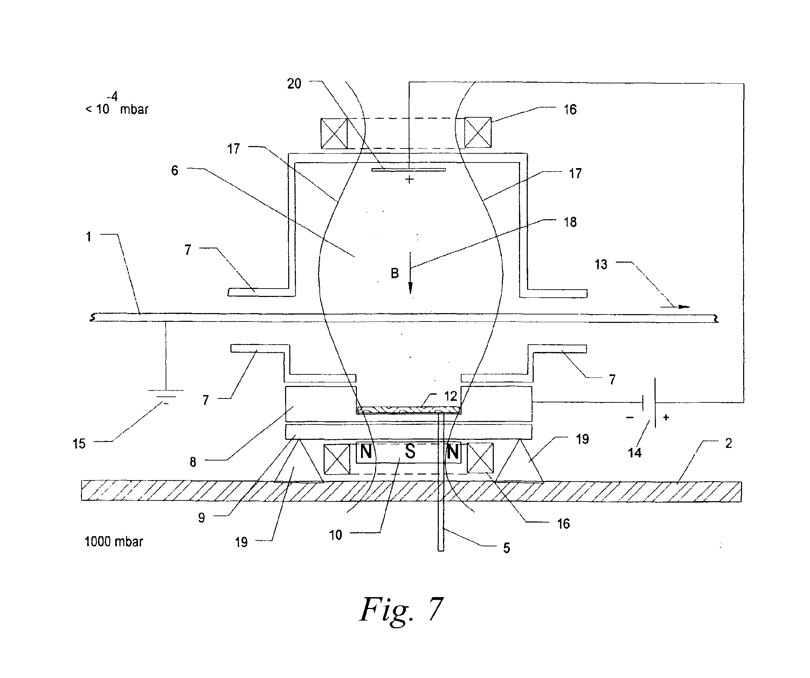

Le dispositif suivant la forme de réalisation particulière de l'invention représentée dans la figure 7 permet d'effectuer un revêtement uniforme sur toutes les faces des substrats 1 qui traversent le dispositif au moyen d'un seul bac de rétention 8 situé en-dessous de ces substrats. A cet effet, le bac de rétention 8 est au moins deux fois plus long dans la direction transverse des substrats que la largeur totale de l'aire projetée par ces substrats sur la surface 12 du métal liquide. La distance entre la surface supérieure de l'enceinte de confinement 7, devant laquelle se trouve une anode 20, et la face supérieure du substrat 1 doit être suffisante pour que la pression de vapeur métallique y soit sensiblement constante. Une distance de plusieurs centimètres, par exemple de 5 à 10 cm, permet de remplir cette condition. En effet, pour de telles distances, le régime d'écoulement du gaz devient visqueux, ce qui augmente fortement la conductance de la section considérée. Afin de permettre la formation de la décharge électrique et donc la présence d'un plasma dans toute l'enceinte de confinement 7, deux solénoïdes 16 sont placés derrière le bac de rétention, d'une part, et derrière l'anode, d'autre part, de manière à créer un champ d'induction magnétique 17 tel que celui représenté dans la figure 7. Ce champ d'induction magnétique est orienté principalement suivant la direction de la flèche 18 et s'étend entre l'anode 20 et la surface 12 du métal liquide, de manière à permettre le transport des électrons de la surface 12 du métal liquide, qui constitue une cathode, jusqu'à l'anode 20. De cette manière la diffusion du plasma dans toute l'enceinte de confinement 7 est obtenue, ce qui permet de réaliser un revêtement métallique compact et adhérent sur toutes les faces du produit.

Un générateur 14, non représenté, est prévu fonctionnant en courant continu ou pulsé, ou encore en courant simplement redressé. Le plasma ne se forme devant la surface 12 de métal liquide que lorsque la polarisation de cette dernière est négative par rapport à l'anode 20. Le bac de rétention 8 et le métal liquide au niveau du réservoir 4 (non représenté) sont connectés au pôle négatif du générateur 14. Le réservoir 4, non représenté, est bien entendu isolé électriquement du potentiel des substrats 1, du potentiel des parois de la chambre à vide 2 et du potentiel des parois de l'enceinte de confinement 7 qui sont maintenues à potentiel flottant.

Dans une autre configuration particulière (non représentée), la partie supérieure de l'enceinte de confinement 7 peut être constituée simplement au moyen d'une anode chaude, c.à.d. à une température évitant le dépôt du métal évaporé sur l'anode. L'étanchéité aussi bien que l'isolation électrique avec les parois latérales de l'enceinte 7 est réalisée par des fentes d'une façon analogue dont est réalisée l'étanchéité entre les parois de l'enceinte 7 et le bac de rétention 8 comme décrit plus haut. L'avantage du dispositif représenté à la figure 7 est sa grande simplicité technologique.

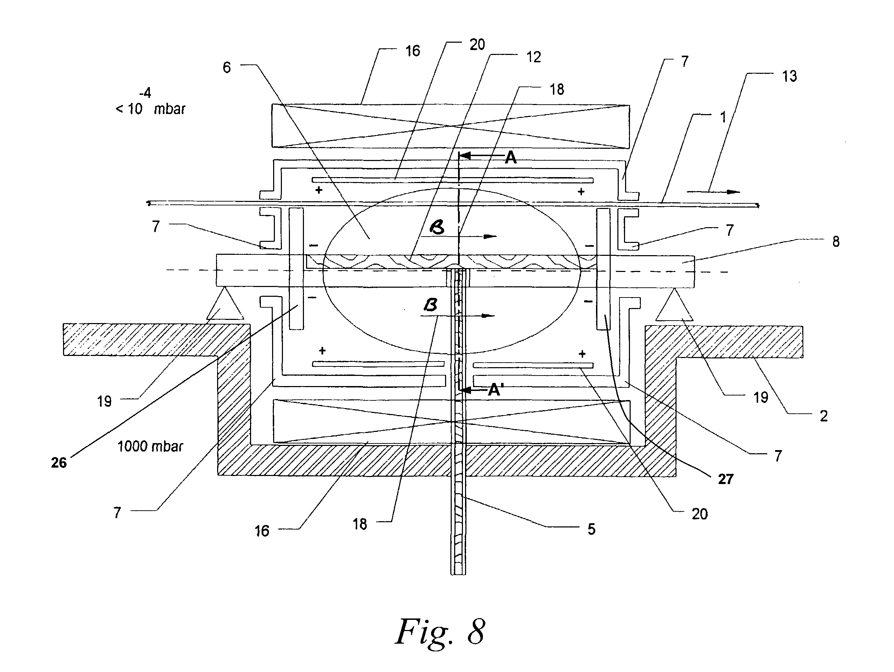

La figure 8 représente une configuration électrique et magnétique particulière permettant de réaliser une décharge magnétron dans une vapeur métallique issue d'un bac de rétention 8, la vapeur métallique s'étendant tout autour de ce bac de rétention 8. Dans ce cas, le bac de rétention 8, construit dans un matériau conducteur de l'électricité, traverse l'enceinte de confinement 7 suivant la direction de déplacement d'un substrat 1. Le bac de rétention 8 traverse les parois latérales de l'enceinte de confinement 7, qui sont à potentiel flottant, sans les toucher, en laissant un espace relativement petit, de quelques millimètres, entre le bac 8 et les parois pour limiter les pertes en métal à travers cet espace et pour permettre le déplacement du bac de rétention par rapport à l'enceinte de confinement 7. Ainsi, le bac de rétention 8 est soutenu et pesé en dehors de l'enceinte de confinement 7 par des supports 19. De cette façon, on évite que le système de pesée soit contaminé par la vapeur métallique. Les supports 19 sont munis de capteurs, non représentés à la figure, permettant la mesure du poids de métal liquide contenu dans le bac de rétention 8.

Le bac de rétention 8 constitue la cathode du système soit par rapport à des anodes chaudes 20, soit par rapport au substrat 1 à revêtir, si ce dernier est conducteur de l'électricité.

Dans une autre configuration encore, non représentée, deux bacs de rétentions peuvent se trouver dans la même enceinte de confinement 7 de manière à pouvoir être polarisés l'un par rapport à l'autre au moyen d'une alimentation fonctionnant en courant alternatif, typiquement à une fréquence comprise entre 1 kHz et 1 MHz et de préférence entre 10 kHz et 100 kHz. Chaque fois qu'un bac de rétention 8 est polarisé négativement l'entièreté de sa surface 12 de métal liquide est bombardée par des ions et des espèces activées contribuant à l'évaporation du métal, alors que l'autre bac joue le rôle d'anode. Le processus s'inverse à la fréquence de fonctionnement de l'alimentation.

L'avantage de cette configuration est d'éviter la formations d'arcs dans la décharge, spécialement dans le cas d'injection d'un gaz réactif, comme par exemple O₂, N₂ et des hydrocarbures.

Le bac de rétention 8 est alimenté en métal liquide au moyen d'un tube 5 désolidarisé par rapport à ce dernier, comme décrit plus haut, et lui même alimenté au moyen d'un réservoir 4 de métal liquide, non représenté dans la figure 8.

Pour pouvoir obtenir la décharge magnétron autour du bac 8, il faut la présence d'un champ d'induction magnétique (B) 18 sensiblement parallèle à la surface du bac de rétention 8. Ce champ d'induction magnétique 18 peut être produit soit au moyen d'un ou plusieurs solénoïdes 16, soit au moyen d'aimants permanents, qui entourent l'enceinte de confinement 7.

La présence du champ d'induction magnétique B perpendiculaire au champ électrique existant dans la gaine cathodique de la décharge électrique contribue à la dérive des électrons dans une direction correspondant à celle du produit vectoriel du vecteur champ magnétique 18 et du vecteur champ électrique dans la gaine cathodique et donc à la diffusion du plasma autour du bac de rétention 8.

On remarque la présence de deux renflements 26 et 27 à l'extrémité du bac de rétention 8. Ces renflements 26 et 27, conducteurs électriques, sont au potentiel de la cathode, c.à.d. au potentiel du bac de rétention 8, et servent à la réflexion électrostatique des électrons vers le centre de la décharge électrique. Au lieu d'utiliser ces réflecteurs électrostatiques, on peut imaginer l'emploi de miroirs magnétiques. Lorsque le bac de rétention 8 est suffisamment long, ces réflecteurs d'électrons ne sont plus indispensables.

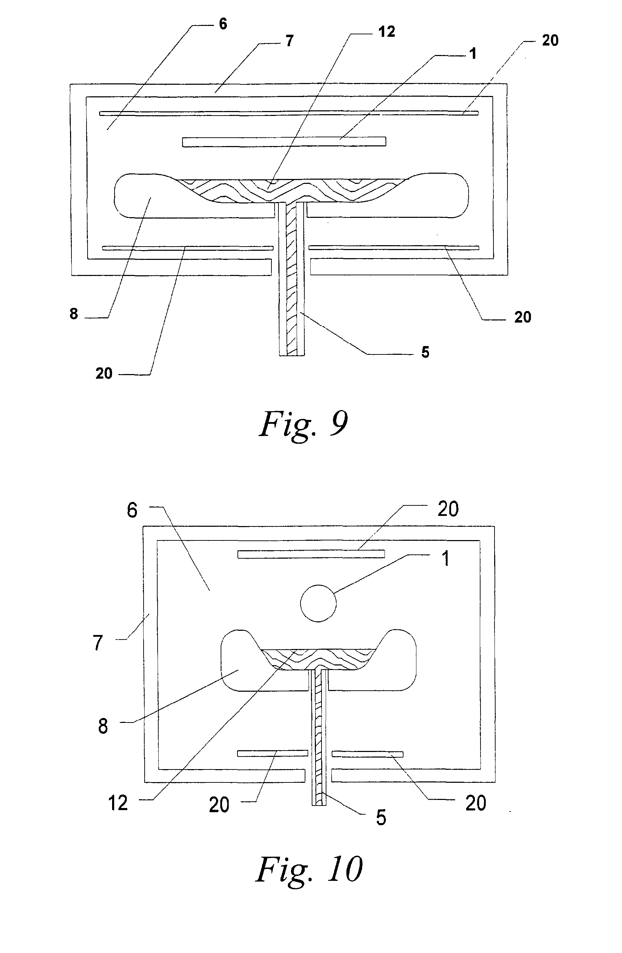

La figure 9 représente une section transversale selon la ligne A-A' de la figure 8. Le bac de rétention 8 se situe entre deux anodes 20 qui se trouvent près des surfaces de l'enceinte de confinement 7. Le substrat 1 en forme de tôle se déplace entre la surface 12 du métal liquide contenu dans le bac de rétention 8 et l'anode supérieure 20. La décharge électrique et la vapeur métallique se forment tout autour du bac de rétention 8 et du substrat 1. Le bac de rétention et la surface du métal liquide est plus large que la largeur maximale de la tôle à traiter.

La figure 10 représente une section transversale analogue à celle de la figure 9 pour un dispositif qui est adapté spécifiquement pour le revêtement de substrats en forme de fils. Le bac de rétention 8 de la figure 10 est relativement étroit et s'étend en-dessous d'un substrat 1 en forme de fil ou de fibre. Les anodes 20 sont maintenues à une température suffisamment élevée afin d'éviter le dépôt des atomes de la vapeur métallique sur ces anodes.

Dans une variante, une seule anode chaude 20 est prévue qui entoure le bac de rétention 8 de sorte que seules les parois transversales à la direction de déplacement du substrat 1 sont maintenues à potentiel flottant. Entre ces parois et l'anode on prévoit une fente afin d'isoler électriquement les parois par rapport à l'anode tout en limitant les pertes en vapeur métallique.

Le procédé mis en oeuvre par le dispositif représenté à la figure 8 est particulièrement bien adapté pour la métallisation de fils et fibres car toute la vapeur et le plasma restent confinés dans l'enceinte de confinement autour d'un bac de rétention 8 qui peut être très étroit de manière à diminuer la consommation d'énergie nécessaire au dépôt.

De plus grâce à l'utilisation d'anodes chaudes 20, il est possible de revêtir des substrat isolants électriques, comme par exemple des fibres optiques.

Dans une configuration particulièrement intéressante, l'anode chaude entoure complètement le bac de rétention. Dans ce cas, il faut simplement assurer une étanchéité et une isolation électrique sans contact entre l'anode et les parois latérales de l'enceinte de confinement en réalisant des fentes étroites au voisinage des zones de l'anode adjacentes aux parois latérales de l'enceinte 7. Les parois latérales de l'enceinte 7, toujours maintenues à potentiel flottant, limitent ainsi la formation d'arcs électriques avec l'anode. Les fentes, assurant un écoulement moléculaire du gaz, réduisent les pertes en vapeur métallique vers la chambre à vide 2. Les différentes parois sont constituées d'un matériau à faible coefficient de collage pour la vapeur métallique et sont suffisamment chaudes pour ne pas être contaminées par cette dernière. L'étanchéité et l'isolation électrique entre les extrémités du bac de rétention 8 et les parois latérales de l'enceinte de confinement 7, à leurs points de traversées, sont assurées de la même manière, c'est-à-dire aussi en réalisant des fentes étroites.

### Exemples d'applications pratiques

### 1. Zingage en continu par plasma froid d'une tôle d'acier laminé à chaud

Afin de revêtir une tôle d'acier laminé à chaud de 1 m de large et de 1 mm d'épaisseur à une vitesse de ligne de 100 m/min, cette dernière est introduite en continu dans une chambre à vide comprenant, outre le dispositif suivant l'invention, des sas en cascades d'entrée et de sortie, ainsi qu'une section de nettoyage par décapage (« etching ») précédant la section de zingage, et une section de passivation par dépôt de chrome par pulvérisation cathodique (« sputtering ») située derrière la section de zingage par plasma froid, avant la sortie de la tôle par le sas de sortie.

Les deux faces de la tôle d'acier sont revêtues simultanément au moyen de huit unités de dépôt du type de celle représentée à la figure 6. On vise un dépôt de zinc, sur deux faces, de 7,5 :m d'épaisseur par face. Ces unités sont capables de revêtir des tôles jusqu'à 1 m de large pour des épaisseurs de produit atteignant 1 cm au maximum. Le traitement des formats moins larges ne pose aucun problème sinon une moindre consommation énergétique par unité de dépôt. Les huit unités de dépôt sont placées par paires dans quatre chambres à vide raccordées chacune à un groupe de pompage moléculaire qui permet d'atteindre en régime de fonctionnement, une pression résiduelle inférieure à 10⁻² Pa dans les chambres à vide à l'extérieur des enceintes de confinement 7.

Chaque dispositif de dépôt, suivant l'invention, est alimenté en vapeur métallique par deux bacs de rétention en graphite 8 pour le zinc liquide 12. Chaque bac de rétention est connecté au pôle négatif d'un générateur 14 en courant continu. Le pôle positif est connecté à la tôle et est donc à la masse du système. La tôle est l'anode du système dans cette configuration. Les bacs ont une forme rectangulaire et ont une dimension de 150 mm x 1000 mm. Le long côté du bac est orienté perpendiculairement au sens de déplacement de la tôle.

Chaque bac de rétention est alimenté en zinc au moyen d'un tube en alumine. Le tube pourrait aussi être en céramique ou en acier revêtu intérieurement de céramique. Le bac de rétention est traversé par le tube 5 tel que représenté dans la figure 2. Le tube 5 affleure au fond du bac 8 et on observe un jeu de 1 mm entre le diamètre extérieur de ce dernier et le diamètre du trou percé dans le bac. Le niveau de zinc 12 dans le bac peut atteindre plus de 4 cm sans provoquer de fuite par l'ouverture laissée par ce jeu. Le tube traverse le bac sur le côté de ce dernier de manière à ne pas gêner le passage de la tôle, vu qu'un des bacs est situé au dessus de la tôle. Des supports 19, non représentés dans la figure 6, sont protégés de la chaleur du bac de rétention 8 par une isolation thermique 9. Sous cette dernière est disposé un réseau d'aimants permanents 10 permettant la réalisation d'une décharge magnétron.

Les supports 19 sont munis de capteurs pour mesurer en permanence le poids de chaque bac de rétention 8. Cette mesure de poids permet un contrôle précis du niveau de métal liquide 12 dans le bac. Le signal envoyé par ces capteurs permet d'assurer la régulation automatique et continue du niveau de métal liquide dans les bacs en faisant varier la pression de gaz injecté dans des réservoirs 4 constitués par des fours d'alimentation et de maintien du métal fondu. La hauteur du zinc dans chacun des bacs de rétention 8 est réglée à 1 cm à partir du fond du bac. Les deux fours, attenant à une même enceinte de confinement, sont isolés électriquement l'un par rapport à l'autre, mais aussi par rapport à tout le reste de l'installation. Le zinc liquide de chaque four 4 est lui aussi mis directement en contact électrique avec la borne négative du générateur 14 du bac de rétention qu'il alimente.

Chaque tube d'alumine 5 traverse la paroi de la chambre à vide 2 au moyen d'un passage étanche, non représenté, et est d'une longueur suffisante pour permettre de compenser, par la hauteur de zinc liquide dans le tube entre le niveau haut du bain dans le four 4 et la surface du zinc liquide 12 dans son bac de rétention 8, des différences de pression entre l'extérieur et l'intérieur de la chambre à vide, typiquement comprises entre 87 780 Pa et 105 070 Pa. Pour ce faire, la longueur du tube 5 est de 2,3 m.

L'étanchéité du dispositif de dépôt pour la vapeur de zinc et pour le plasma est assurée au moyen d'une enceinte de confinement 7, telle que représentée à la figure 6. Les fentes d'entrée 21 et de sortie 22 ont une section transverse au sens de déplacement de la bande de 20 mm x 1000 mm pour une longueur de 100 mm. Les pertes dues à ces fentes sont inférieures à 1 kg de Zn par semaine, en régime de production. Les pertes les plus lourdes sont observées au niveau des joints chauds constitués par des fentes de 3 mm sur une longueur de 100 mm et situés à proximité des surfaces supérieures des bacs de rétention 8 qui affleurent au niveau des surfaces extérieures des parois de l'enceinte de confinement 7. Ces pertes de matière sont inférieures à 10 kg par 24 h, en régime de production pour chaque unité de dépôt du type représenté à la figure 6.

Le zinc perdu par l'enceinte de confinement est récupéré dans la chambre à vide, sous forme solide, par condensation sur des plaques froides, non représentées, prévues à cet effet. Ce zinc est finalement réintroduit dans le four 4.

Les parois de l'enceinte de confinement 7 sont isolées électriquement de la tôle, du bac de rétention et de la chambre à vide. Elles sont à potentiel flottant. Ces parois sont doubles de manière à former des cavités à l'intérieur desquelles on protège un système de chauffage par effet Joule. Ce système de chauffage permet aux faces intérieures des parois de l'enceinte de confinement 7 d'atteindre une température de l'ordre de 450°C, suffisante pour leur éviter toute contamination par le zinc. Le générateur de courant permettant ce chauffage de parois est isolé électriquement du reste de l'installation afin de maintenir les parois de l'enceinte de confinement 7 à potentiel flottant.

Les parois sont conçues pour pouvoir se dilater et se contracter sans détérioration de l'étanchéité du système. Les surfaces extérieures de l'enceinte de confinement 7 sont fabriquées en acier inoxydable (« inox ») poli de faible émissivité (0,25), tandis que les surfaces intérieures sont construites en inox oxydé à haute température, de plus haute émissivité (0,85), afin d'absorber le rayonnement produit par le système de chauffage et chauffer préférentiellement les surfaces intérieures de l'enceinte de confinement 7. Cette configuration a pour avantage de minimiser la consommation énergétique nécessaire au chauffage de l'enceinte de confinement 7.

Pour pouvoir assurer le bon fonctionnement de la décharge au niveau de la cible supérieure, c.à.d. au niveau du bac de rétention 8 situé au dessus de la tôle, dans la figure 6, un solénoïde 16 est disposé autour de l'enceinte de confinement 7 afin de produire un champ d'induction dont l'intensité est supérieure à 0,005 T (50 Gauss). Ce champ permet, d'une part, d'assurer le retour des électrons de la cible supérieure vers la tôle qui constitue une anode, et, d'autre part, assure une diffusion préférentielle du plasma le long des lignes de champ d'induction magnétique plutôt que perpendiculairement à ces dernières.

En régime de fonctionnement du dispositif de dépôt, suivant l'invention, pour une tôle de 1 m de large traversant le dispositif à une vitesse de 100 m/min, chacun des seize générateurs en courant continu des huit dispositifs de dépôt consomme une puissance de 30 kW sous une différence de potentiel de 950 V. Chacun des seize fours, tous étant isolés électriquement les uns des autres et de la masse, est équipé d'une puissance de chauffe de 4 kW. Chaque système de chauffage des parois des enceintes de confinement consomme 10 kW, soit une puissance totale de 80 kW pour les huit unités de dépôt.

La puissance totale nécessaire à la réalisation d'un dépôt de Zn de 7,5 :m d'épaisseur sur les deux faces de la tôle à une vitesse de ligne de 100 m/min en 1 m de large est donc de 624 kW.

### 2. Métallisation en continu d'une fibre optique par plasma froid

Une fibre optique est traitée en continu dans le dispositif, suivant l'invention, sous vide par plasma froid à une vitesse de 1000 m/min. L'entrée et la sortie du dispositif sont équipées de sas en cascades. Préalablement au traitement de métallisation par plasma froid, la fibre est nettoyée en surface en passant dans un plasma d'argon et d'oxygène avant d'être sensibilisée par un dépôt de chrome de quelques nanomètres réalisé par pulvérisation cathodique (« sputtering »). Le dépôt de métal produit dans l'étape suivante du procédé par un dispositif suivant l'invention est passivé par une couche de 10 nm de chrome, elle aussi réalisée par pulvérisation cathodique avant sortie de la fibre de la chambre à vide via le sas de sortie.

L'étape de métallisation consiste soit à réaliser une couche de 5 :m de Zn, soit une couche de 5 :m de Sn à la surface de la fibre. La métallisation est effectuée dans un dispositif tel que représenté à la figure 8, avec cependant une modification en ce qui concerne l'enceinte de confinement.

L'enceinte de confinement est principalement constituée par une anode cylindrique de diamètre intérieur de 150 mm, en graphite entourant un bac de rétention 8, lui aussi en graphite, de section semi-cylindrique et de diamètre de 40 mm. L'étanchéité latérale est assurée au moyen de deux parois de l'enceinte de confinement à potentiel flottant, en graphite. Les pertes en vapeurs métalliques sont limitées par la réalisation de fentes étroites entre ces parois latérales et respectivement l'anode et le bac de rétention du métal 8.

La longueur du bac de rétention utile au dépôt à l'intérieur de l'enceinte de confinement est de 1 m. L'anode peut être chauffée, ainsi que les parois latérales à potentiel flottant, par effet Joule. Les potentiels respectifs des différentes parois ne sont pas modifiés par le système de chauffage. Les pertes radiatives de l'enceinte de confinement sont éventuellement limitées au moyen d'un ou de plusieurs cylindres en acier inoxydable (« inox ») poli avec une émissivité de 0,25, à potentiel flottant entourant l'anode. La fibre traverse le dispositif de part en part sur toute sa longueur. Le bac de rétention traverse les parois latérales afin de pouvoir être soutenu par les supports 19 munis du dispositif de pesée.

Entre le tube 5 pour l'alimentation en métal liquide et le bac de rétention 8 existe un jeu inférieur à 1 mm. Le tube d'alimentation est composé d'alumine.

Dans ce dispositif, une décharge magnétron est produite dans la vapeur métallique autour du bac de rétention, constituant la cathode du système du fait de la présence d'un champ d'induction magnétique 18 de 0,05 T (ou 500 Gauss) obtenu au moyen d'un solénoïde 16 entourant le dispositif de dépôt sur toute sa longueur. Des rebords 26 et 27 situés aux deux extrémités du bac de rétention permettent le retour des électrons vers le centre de la décharge par réflexion électrostatique.

### Zingage en continu de la fibre optique par plasma froid :

Pour produire un dépôt de 5 :m de Zn sur une fibre optique de diamètre de 100 :m à une vitesse de ligne de 1000 m/min, il faut prévoir huit dispositifs de dépôt de 1 m de longueur utile du type tel que représenté à la figure 8. Chacun des huit bacs de rétention 8 du zinc liquide est alimenté par son propre réservoir 4 constitué par un four, isolé électriquement à la fois par rapport aux autres fours, mais aussi par rapport à la masse de l'installation.

La consommation en zinc est de 673 g/h par fibre. Pour une fibre, la puissance nécessaire au dépôt sert principalement à compenser les pertes énergétiques étant donné la faible consommation en zinc. La puissance à fournir à chaque système de dépôt est de 1,2 kW pour le dépôt et de 2 kW pour le chauffage par effet Joule de l'anode. Il en résulte une consommation totale de 26 kW pour l'obtention du dépôt visé.

### Etamage en continu de la fibre optique par plasma froid :

Pour produire un dépôt de 5 :m de Sn sur une fibre optique de diamètre de 100 :m à une vitesse de ligne de 1000 m/min il faut prévoir 25 installations de dépôt du type précédent. La consommation en métal est de l'ordre de 700 g/h et la puissance nécessaire au dépôt est de 2 kW par système de dépôt. Pour un seul blindage d'acier inoxydable entourant l'anode chaude qui est à 1300°C, la perte radiative atteint 41 kW par système de dépôt. Quatre cylindres concentriques permettent de réduire cette perte à 1 kW environ. La puissance nécessaire totale minimum à la réalisation du dépôt visé est donc de 75 kW.

### 3. Zingage en continu par plasma froid d'un fil d'acier doux

Le zingage d'un fil d'acier doux par plasma froid est réalisé avec le même type de système de dépôt que celui utilisé pour le zingage d'une fibre optique, c.à.d. tel que représenté à la figure 8. Il est simplement adapté au niveau des entrée et sortie pour limiter les pertes en vapeur de zinc et permettre le passage d'un fil de 5 mm de diamètre. Les pertes d'entrée et de sortie sont limitées en faisant passer le fil par des cylindres creux de 50 mm de long et de 10 mm de diamètre intérieur fixés respectivement aux parois latérales d'entrée et de sortie de l'enceinte de confinement de la vapeur métallique.

Deux dispositifs de dépôt de 1 m de longueur utile suffisent à produire un dépôt de 5 :m de Zn sur le fil à une vitesse de ligne de 300 m/min moyennant une consommation de 4 kW pour le dépôt, par système de dépôt.

Il faut en outre chauffer l'anode par effet Joule pour compenser une perte radiative de l'ordre de 4 kW par système de dépôt. La puissance totale nécessaire au zingage du fil vaut donc 16 kW, c.à.d. 8 kW par système de dépôt, pour une consommation en zinc de 10 kg par heure, c.à.d. une consommation de 5 kg/h par système de dépôt.

Comme illustré dans la description, la présente invention réalise un plasma dans une enceinte relativement étanche à la vapeur métallique, aux parois chaudes et pour laquelle les jonctions des surfaces de potentiels antagonistes, en particulier l'anode et la cathode, se font par des parois chaudes à potentiel flottant. L'isolation électrique est réalisée en laissant un espace libre sous forme d'une fente la plus étroite possible entre les surfaces à isoler. L'utilisation d'un isolant électrique à l'intérieur de l'enceinte de confinement conduirait rapidement à la formation de courts-circuits électriques par contamination par dépôt de vapeur métallique. Différentes configurations sont proposées qui permettent de métalliser la face supérieure d'un substrat. De préférence, un champ magnétique est utilisé pour assurer le retour des électrons vers l'anode.

L'invention réalise aussi un système d'alimentation en métal liquide qui comporte un tube sans liaison mécanique avec le bac de rétention de ce métal. Il est donc possible de contrôler et de réguler le niveau du métal dans le bac de rétention, formant la cible, par simple pesée de ce dernier.

Il est bien entendu que l'invention n'est pas limitée aux différentes formes de réalisation du procédé et du dispositif décrites ci-dessus et représentées aux figures annexées, mais que bien des variantes peuvent être envisagées en ce qui concerne notamment la construction et la forme de l'enceinte de confinement 7, la position et la forme des anodes et des solénoïdes ou des aimants permanents, sans sortir du cadre de cette invention.

Ainsi, d'autres moyens de réglage peuvent être prévus pour modifier le niveau du métal liquide dans le réservoir étanche 4, par exemple en y introduisant du métal liquide. Dans certains cas, on peut faire usage d'une contre-électrode formée d'un élément conducteur d'électricité séparé, même si le substrat lui-même est conducteur d'électricité. Dans d'autres cas encore aussi bien le substrat conducteur d'électricité que l'élément séparé peuvent former simultanément la contre-électrode.

La section de l'ouverture d'entrée et de l'ouverture de sortie de l'enceinte de confinement est adaptée à la forme de la section transversale des substrats à revêtir. Ainsi, pour des substrats de section circulaire l'ouverture d'entrée et de sortie présentent la forme d'une tubulure cylindrique dont le diamètre intérieur est légèrement supérieur, de 2 à 5 mm par exemple, au diamètre extérieur du substrat.

## Revendications

1. Procédé pour le dépôt d'une couche métallique sur un substrat (1) suivant lequel on réalise le dépôt par plasma froid à l'intérieur d'une enceinte de confinement (7) chauffée de manière à éviter la formation d'un dépôt métallique à sa surface, cette enceinte (7) présentant une ouverture d'entrée (21) et une ouverture de sortie (22) par lesquelles le substrat (1) à revêtir entre et sort de celle-ci, une source de vapeur métallique, constituant une électrode, étant prévue dans cette enceinte (7) permettant la formation du plasma (6) dans cette dernière, une contre-électrode étant formée par le substrat (1) ou par un élément conducteur d'électricité séparé, **caractérisé en ce que** l'on introduit le métal, dont il y a lieu de former la couche métallique sur le substrat (1), à l'état liquide dans un bac de rétention (8) communiquant avec l'enceinte de confinement (7) et à ce que l'on maintient le métal liquide dans ce bac (8) à un niveau sensiblement constant durant la formation de cette couche métallique.

2. Procédé suivant la revendication 1, **caractérisé en ce que** l'on chauffe sensiblement uniformément le métal liquide dans le bac de rétention (8) par plasma, en particulier en formant une décharge magnétron à proximité de ce bac (8), et de préférence au moins partiellement autour de celui-ci.

3. Procédé suivant l'une ou l'autre des revendications 1 ou 2, **caractérisé en ce que** l'on mesure, de préférence d'une manière sensiblement continue, le niveau du métal dans le bac de rétention (8) et **en ce que** l'on alimente le bac (8) en métal liquide en fonction du niveau mesuré dans ce dernier.

4. Procédé suivant l'une quelconque des revendications 1 à 3, **caractérisé en ce que** l'on pèse le bac de rétention (8) afin de déterminer le niveau du métal liquide et **en ce que** l'on alimente le bac de rétention (8) en métal liquide en fonction du poids mesuré.

5. Procédé suivant l'une quelconque des revendications 1 à 4, **caractérisé en ce qu'**on alimente le bac de rétention (8) à partir d'un réservoir à métal liquide (4) extérieur à l'enceinte (7) précitée par un réglage de la différence de pression existant entre l'intérieur de l'enceinte (7) et un gaz présent dans le réservoir (4).

6. Procédé suivant l'une quelconque des revendications 1 à 5, **caractérisé en ce que** l'on alimente le bac de rétention (8) à partir d'un réservoir à métal liquide (4), dans lequel le niveau du métal est inférieur au niveau du métal liquide dans le bac de rétention (8), par un réglage de la hauteur du réservoir (4) en fonction du niveau du métal dans le bac de rétention (8).

7. Procédé suivant l'une quelconque des revendications 1 à 6, **caractérisé en ce que** l'on maintien au moins la partie de l'enceinte de confinement (7) voisine à la source de vapeur métallique à un potentiel flottant.

8. Procédé suivant l'une quelconque des revendications 1 à 7, **caractérisé en ce que**, lorsque le substrat (1) à revêtir est non conducteur d'électricité, on fait usage d'une électrode séparée (20) installée dans l'enceinte de confinement (7) et chauffée à une température suffisamment élevée pour éviter d'être contaminée par la vapeur métallique.

9. Procédé suivant l'une quelconque des revendications 1 à 7, **caractérisé en ce que**, lorsque le substrat (1) à revêtir est conducteur d'électricité, celui-ci est maintenu à un potentiel positif par rapport à la source de vapeur métallique en formant ainsi une anode, la source de vapeur formant une cathode.

10. Procédé suivant l'une quelconque des revendications 1 à 9, **caractérisé en ce que** l'on applique un potentiel alternatif à l'électrode et à la contre-électrode.

11. Procédé suivant l'une quelconque des revendications 1 à 10, **caractérisé en ce que**, lorsque le substrat (1) présente la forme d'une bande dont seulement une face est à revêtir par une couche métallique, la face du substrat (1) ne devant pas être revêtue se déplace à une distance de moins d'un centimètre des parois intérieures de l'enceinte de confinement (7).

12. Procédé suivant l'une quelconque des revendications 1 à 11, **caractérisé en ce que** les parois de l'enceinte de confinement (7) sont chauffées par effet Joule.

13. Dispositif pour le dépôt d'une couche métallique sur un substrat (1), comprenant **(a)** une enceinte de confinement (7) présentant une ouverture d'entrée (21) et une ouverture de sortie (22) par lesquelles le substrat (1) à revêtir par la couche métallique peut entrer et sortir de cette enceinte (7), **(b)** des moyens pour chauffer les parois de cette enceinte (7), **(c)** au moins un bac de rétention (8) pour un métal liquide communiquant avec cette enceinte (7) et constituant une électrode, **(d)** une contre-électrode formée par le substrat (1) ou par un élément séparé (20) conducteur d'électricité, et **(e)** des moyens pour la formation d'un plasma (6) dans cette enceinte (7) au moins au-dessus du métal liquide, **caractérisé en ce que** des moyens sont prévus pour maintenir le métal liquide à un niveau sensiblement constant.

14. Dispositif suivant la revendication 13, **caractérisé en ce qu'**un espace libre est prévu entre l'enceinte (7) et le bac de rétention (8).

15. Dispositif suivant la revendication 14, **caractérisé en ce que** l'espace libre précité est formé par une fente présentant une largeur comprise entre 0,5 et 5 mm, et de préférence de l'ordre de 2 à 3 mm.

16. Dispositif suivant l'une quelconque des revendications 13 à 15, **caractérisé en ce que** le bac de rétention (8) coopère avec des moyens permettant de mesurer la quantité de métal liquide présent dans ce bac de rétention (8).

17. Dispositif suivant l'une quelconque des revendications 13 à 16, **caractérisé en ce qu'**il comprend un réservoir (4), communiquant avec le bac de rétention (8), qui contient du métal liquide dont le niveau est inférieur au niveau du métal liquide du bac de rétention (8), des moyens étant prévus pour alimenter sensiblement en continu le bac de rétention (8) en métal liquide à partir dudit réservoir (4).

18. Dispositif suivant la revendication 17, **caractérisé en ce que** des moyens de réglage sont prévus permettant de faire varier la hauteur du niveau du métal liquide dans le réservoir (4) et/ou de ce dernier en fonction du niveau du métal liquide dans le bac de rétention (8) afin de tenir ce dernier sensiblement constant.

19. Dispositif suivant l'une quelconque des revendications 17 ou 18, **caractérisé en ce que** le réservoir (4) précité est contenu dans d'un four.

20. Dispositif suivant l'une quelconque des revendications 13 à 19, **caractérisé en ce qu'**il comprend un tube d'alimentation (5) pour le métal liquide débouchant dans le bac de rétention (8), ce tube (5) étant mécaniquement indépendant du bac de rétention (8).

21. Dispositif suivant la revendication 20, **caractérisé en ce que** le tube d'alimentation (5) pour le métal liquide s'étend à travers une paroi du bac de rétention (8), de préférence à travers la paroi inférieure du bac (8), un jeu étant prévu entre la paroi et le tube (5) d'une telle dimension que le métal ne puisse pas couler à travers ce jeu grâce à la tension superficielle du métal, tout en permettant au bac de rétention (8) et au tube (5) de se mouvoir librement l'un par rapport à l'autre.

22. Dispositif suivant l'une quelconque des revendications 13 à 21, **caractérisé en ce qu'**il comprend des moyens de confinement magnétique pour le plasma.

23. Dispositif suivant la revendication 22, **caractérisé en ce que** les moyens de confinement comprennent un solénoïde (16) disposé par rapport à l'enceinte de confinement (7) d'une telle manière qu'un champ d'induction magnétique (18) est créé s'étendant entre la surface à revêtir du substrat (1) et le bac de rétention (8).

24. Dispositif suivant la revendication 22, **caractérisé en ce que** les moyens de confinement comprennent un solénoïde (16) qui entoure l'enceinte de confinement (7) d'une telle manière à créer un champ d'induction magnétique (18) tout autour du bac de rétention (8) traversant cette enceinte (7).

25. Dispositif suivant l'une des revendications 13 à 24, **caractérisé en ce que** des moyens sont prévus pour chauffer les parois de l'enceinte de confinement (7) par effet Joule à une température suffisamment élevée pour éviter la condensation du métal sur ces parois.

26. Dispositif suivant l'une quelconque des revendications 13 à 25, **caractérisé en ce que** l'ouverture d'entrée (21) et l'ouverture de sortie (22) de l'enceinte de confinement (7) sont formées par des tubulures chauffées dont la section transversale présente sensiblement la forme de la section du substrat (1) et une dimension légèrement supérieure à celle du substrat (1) à revêtir, la longueur de ces tubulures dans la direction de déplacement du substrat (1) étant au moins deux fois la dimension de l'espace libre mesuré entre la surface extérieure du substrat (1) et la surface intérieure de l'ouverture (21,22).

27. Dispositif suivant l'une quelconque des revendications 13 à 26, **caractérisé en ce qu'**il comprend deux bacs de rétention (8) séparés isolés électriquement l'un par rapport à l'autre, des moyens étant prévus pour soumettre ces bacs (8) alternativement à un potentiel positif et négatif l'un par rapport à l'autre.

28. Dispositif suivant l'une quelconque des revendications 13 à 27, **caractérisé en ce que** des moyens sont prévus pour permettre au substrat (1) de traverser la vapeur métallique créée dans l'enceinte de confinement (7) et ainsi de recouvrir toutes les faces extérieures du substrat (1).
